# EUROPEAN PATENT APPLICATION

(11) **EP 4 757 176 A1**
(43) Date of publication of application: **10.06.2026**
(21) Application number: 25205477.0
(22) Date of filing: 29.09.2025
(51) Int. Cl.: H03F 3/217, H03K 17/284, H03F 1/02, H03F 1/52, H03K 17/13, H03K 17/14, H03F 3/187

(54) **INTEGRATED CIRCUIT FOR CLASS-D AUDIO AMPLIFIER**

(30) Priority: 06.12.2024 US 202418972053
(71) Applicant: Monolithic Power Systems, Inc., Kirkland, WA 98033 (US)
(72) Inventor: DOOPER, Lûtsen Ludgerus Albertus Hendrikus, Kirkland (US)
(74) Representative: Mewburn Ellis LLP

(57) **Abstract**

An integrated circuit (IC) for a class-D audio amplifier has a first pin (104) to receive a pulse modulated signal, a second pin (105) to provide an output voltage, a high-side power switch and a low-side power switch coupled in series to form an output node (122). The output node is coupled to the second pin (105). A controller (13) extends a first time interval between turning off the low-side power switch and turning on the high-side power switch when an output current flowing into the second pin (105) from the load (15) is below a time extension threshold. The controller (13) further extends a second time interval between turning off the high-side power switch and turning on the low-side power switch when the output current flowing from the second pin (105) to the load (15) is below the time extension threshold.

## Description

### TECHNICAL FIELD

The present invention generally relates to electronic circuits, and more particularly but not exclusively relates to class-D audio amplifiers.

### BACKGROUND OF THE INVENTION

An audio power amplifier comprises basic electronic circuitry that amplifies a low-power electronic audio signal to a high-power signal for driving a loudspeaker. The audio power amplifier can be combined with a chain of electronic components or circuits, each performing an individual task or contributing to a common task. Essentially, any audio signal can be provided to the audio power amplifier, as is commonly done. The output power of the audio power amplifier can range from a few watts to tens or hundreds of watts, and sometimes even more.

Class-D audio amplifiers are widely used because of their high-power efficiency. Generally, a class-D audio amplifier is an amplifier in which transistors are configured as switches. An input audio signal provided to the class-D audio amplifier is modulated into a pulse stream, typically using a pulse width modulation signal. Subsequently the pulse stream is amplified by a power stage having power switches. Finally, the input audio signal can be easily reconstructed by applying the amplified pulse stream to a low pass filter.

The power switches in the power stage of the class-D audio amplifier have relatively low power loss. When a power switch is on, all the output current flows through it with almost no voltage drop generated across it, resulting in low power loss. And when the power switch is turned off, no current flows through it, also resulting in no power loss. The low pass filter does not consume energy because it is generally constructed using an inductor and a capacitor. In practice, however, the power efficiency of the class-D audio amplifier is determined by switching losses caused by turning on and off the power switches, as well as parasitic losses resulting from parasitic parameters of the power switches and the low pass filter.

### BRIEF DESCRIPTION OF THE DRAWINGS

Figure 1 shows a block diagram of a class-D audio amplifier (100) in accordance with an embodiment of the present invention.
Figure 2 shows a timing diagram (200) of the pulse modulator (11) (shown in Figure 1) in accordance with an embodiment of the present invention.
Figure 3A shows a schematic diagram of an IC (103A) in accordance with an embodiment of the present invention.
Figure 3B shows a state diagram (300) of the IC (103A) in accordance with an embodiment of the present invention.
Figure 4 shows a schematic diagram of the current level detector (129A) of Figure 3A in accordance with an embodiment of the present invention.
Figure 5 shows a schematic diagram of a power stage (12A) with parasitic capacitances in accordance with an embodiment of the present invention.
Figure 6 shows a timing diagram indicating the output current lo with 50% modulation in accordance with an embodiment of the present invention.
Figures 7-11 show timing diagrams of the power stage 12A in accordance with an embodiment of the present invention.
Figure 12 shows a block diagram of a class-D audio amplifier (1200) in accordance with an embodiment of the present invention.
Figure 13 illustrates a control method (1300) of a class-D audio amplifier in accordance with an embodiment of the present invention.
The use of the similar reference label in different drawings indicates the same of like components.

### SUMMARY OF THE INVENTION

It is one of the objects of the present invention to provide an improved integrated circuit (IC) for the class-D audio amplifier.

One embodiment of the present invention discloses an integrated circuit (103) for a class-D audio amplifier (100). The integrated circuit (103) comprises a first pin (104), a second pin (105), a power stage (12), and a controller (13). The first pin (104) is configured to receive a pulse modulated signal (PWM1). The second pin (105) is configured to provide an output voltage (Vout) via amplifying the pulse modulated signal (PWM1). The output voltage (Vout) is used to drive a load (15) via an output filter (14). The power stage (12) comprises a high-side power switch (125) and a low-side power switch (126). A first end of the high-side power switch (D1) is coupled to a first power supply voltage (Vddp), a second end of the high-side power switch (S1) is coupled to a first end of the low-side power switch (D2) to form an output node (122), and a second end of the low-side power switch (S2) is coupled to a second power supply voltage (Vssp). The output node (122) is coupled to the second pin (105) to provide the output voltage (Vout). The controller (13) is coupled to the first pin (104) to receive the pulse modulated signal (PWM1) and provide a first switching control signal (Dr1) and a second switching control signal (Dr2) based on the pulse modulated signal (PWM1). The first switching control signal (Dr1) and the second switching control signal (Dr2) are configured to turn on the high-side power switch (125) and the low-side power switch (126) alternately, to transition the output voltage (Vout) between the first power supply voltage (Vddp) and the second power supply voltage (Vssp). The controller (13) is configured to extend a first time interval (Dt1) between turning off the low-side power switch (126) and turning on the high-side power switch (125) when an output current (lo) flowing into the second pin (105) from the load (15) is below a time extension threshold. The controller (13) is configured to extend a second time interval (Dt2) between turning off the high-side power switch (125) and turning on the low-side power switch (126) when the output current (lo) flowing from the second pin (105) to the load (15) is below the time extension threshold.

Another embodiment of the present invention discloses an integrated circuit (203) for a class-D audio amplifier (1200). The integrated circuit (203) comprises a first pin (104), a second pin (106), a third pin (105), a fourth pin (107), a first power stage, a second power stage, and a controller (23). The first pin (104) is configured to receive a first pulse modulated signal (PWM1). The second pin (106) is configured to receive a second pulse modulated signal (PWM2). The third pin (105) is configured to provide a first output voltage (Vout) via amplifying the first pulse modulated signal (PWM1), and the third pin (105) is configured be coupled to a first end of a load (15) via a first output filter (14). The fourth pin (107) is configured to provide a second output voltage (Vout2) via amplifying the second pulse modulated signal (PWM2), and the fourth pin (107) is configured be coupled to a second end of the load (15) via a second output filter (24). The first power stage comprises a first high-side power switch (125) and a first low-side power switch (126) coupled in series between a first power supply voltage (Vddp) and a second power supply voltage (Vssp). The first high-side power switch (125) is coupled to the first low-side power switch (126) to form a first output node (122), and the first output node (122) is coupled to the third pin (105). The second power stage comprises a second high-side power switch (225) and a second low-side power switch (226) coupled in series between the first power supply voltage (Vddp) and the second power supply voltage (Vssp). The second high-side power switch (225) is coupled to the second low-side power switch (226) to form a second output node (222), and the second output node (222) is coupled to the fourth pin (107). The controller (23) is coupled to the first pin (104) to receive the first pulse modulated signal (PWM1), and coupled to the second pin (106) to receive the second pulse modulated signal (PWM2), and is configured to provide a first (Dr1) and a second (Dr2) switching control signals based on the first pulse modulated signal (PWM1), and provide a third (Dr3) and a fourth (Dr4) switching control signals based on the second pulse modulated signal (PWM2). The first (Dr1) and second (Dr2) switching control signals are configured to turn on the first high-side power switch (125) and the first low-side power switch (126) alternately. The third (Dr3) and fourth (Dr4) switching control signals are configured to turn on the second high-side power switch (225) and the second low-side power switch (226) alternately. The controller (23) is configured to adjust a first time interval (Dt1) between turning off the first low-side power switch (126) and turning on the first high-side power switch (125) and adjust a second time interval (Dt2) between turning off the first high-side power switch (125) and turning on the first low-side power switch (126) in response to a first output current (lo) flowing through the third pin (105). The controller (23) is configured to adjust a third time interval (Dt3) between turning off the second low-side power switch (226) and turning on the second high-side power switch (225) and to adjust a fourth time interval (Dt4) between turning off the second high-side power switch (225) and turning on the second low-side power switch (226) in response to a second output current (lo2) flowing through the fourth pin (107).

Yet another embodiment of the present invention discloses an integrated circuit (103) for a class-D audio amplifier (100). The integrated circuit (103) comprises a first pin (104), a second pin (105), a power stage (12), and a controller (13). The first pin (104) is configured to receive a pulse modulated signal (PWM1). The second pin (105) is configured to provide an output voltage (Vout). The power stage (12) comprises a high-side power switch (125) and a low-side power switch (126). A first end of the high-side power switch (D1) is coupled to a first power supply voltage (Vddp), a second end of the high-side power switch (S1) is coupled to a first end of the low-side power switch (D2) to form an output node (122), and a second end of the low-side power switch (S2) is coupled to a second power supply voltage (Vssp). The output node (122) is coupled to the second pin (105) to provide the output voltage (Vout). The controller (13) is coupled to the first pin (104) to receive the pulse modulated signal (PWM1) and provide a first switching control signal (Dr1) and a second switching control signal (Dr2) based on the pulse modulated signal (PWM1). The first switching control signal (Dr1) and the second switching control signal (Dr2) are configured to turn on the high-side power switch (125) and the low-side power switch (126) alternately, to transition the output voltage (Vout) between the first power supply voltage (Vddp) and the second power supply voltage (Vssp). The controller (13) is configured to extend a time interval (Dt1) between turning off the low-side power switch (126) and turning on the high-side power switch (125) when an output current (lo) flowing into the second pin (105) from the load (15) is below a time extension threshold.

These and other features of the present invention will be readily apparent to people of ordinary skills in the art upon reading the entirety of this disclosure, which includes the accompanying drawings and claims.

### DETAILED DESCRIPTION

Reference will now be made in detail to the preferred embodiments of the invention, examples of which are illustrated in the accompanying drawings. While the invention will be described in conjunction with the preferred embodiments, it will be understood that they are not intended to limit the invention to these embodiments. On the contrary, the invention is intended to cover alternatives, modifications and equivalents, which may be included within the spirit and scope of the invention as defined by the appended claims. Furthermore, in the following detailed description of the present invention, numerous specific details are set forth in order to provide a thorough understanding of the present invention. However, it will be obvious to one of ordinary skills in the art that the present invention may be practiced without these specific details. In other instances, well-known methods, procedures, components, and circuits have not been described in detail so as not to unnecessarily obscure aspects of the present invention.

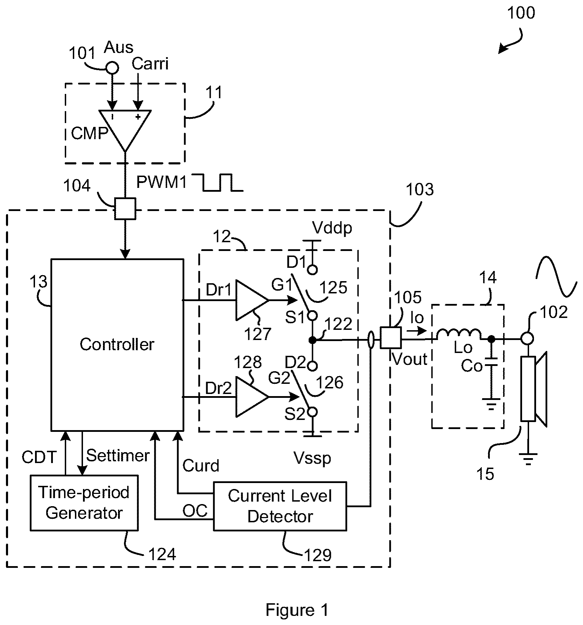

Figure 1 shows a block diagram of a class-D audio amplifier 100 in accordance with an embodiment of the present invention. In the embodiment of Figure 1, the class-D audio amplifier 100 has an input terminal 101, an output terminal 102, a pulse modulator 11, a power stage 12, a controller 13, and an output filter 14. The input terminal 101 is configured to receive an audio signal Aus. The output terminal 102 is coupled to one end of a load 15 (e.g., a speaker) and is configured to amplify and reconstruct the audio signal Aus to the load 15. In the embodiment of Figure 1, the other end of the load 15 is coupled to a reference ground. The pulse modulator 11 receives the audio signal Aus and converts the audio signal Aus into a pulse modulated signal PWM1. In one embodiment, the pulse modulated signal PWM1 may be a pulse width modulated signal, a pulse density modulated signal, or other suitable pulse signals. In the embodiment of Figure 1, the pulse modulator 11 comprises a comparator CMP, which is employed to provide the pulse modulated signal PWM1 via comparing the audio signal Aus with a carrier signal Carri (e.g., having a triangle shape). One with ordinary skills in the art should also understand that the pulse modulator 11 may employ other suitable circuit structure without detracting merits of the present invention. In the embodiment of Figure 1, the power stage 12 and the controller 13 are integrated in an integrated circuit (IC) 103. The IC 103 has pins 104-105. The pin 104 is coupled to the pulse modulator 11 to receive the pulse modulated signal PWM1, the pin 105 is coupled to an output node 122 formed by the power stage 12 and is configured to provide the output voltage Vout and the output current lo.

The power stage 12 has a pair of power switches (e.g., a high-side power switch 125 and a low-side power switch 126) coupled in series between a power supply voltage Vddp and a power supply voltage Vssp. In one embodiment, the power supply voltage Vddp is higher than the power supply voltage Vssp. For example, the power supply voltage Vddp is coupled to a positive supply rail, and the power supply voltage Vssp is coupled to a negative supply rail or the reference ground. A first end D1 of the high-side power switch 125 is coupled to the power supply voltage Vddp, a second end S1 of the high-side power switch 125 and a first end D2 of the low-side power switch 126 are coupled together to form the output node 122, and a second end S2 of the low-side power switch 126 is coupled to the power supply voltage Vssp. The output node 122 is configured to provide an output voltage Vout and an output current lo to drive the load 15 via the output filter 14. In the embodiment of Figure 1, the output filter 14 comprises an inductor Lo and a capacitor Co, and the output voltage Vout is filtered via the output filter 14 to reconstruct the audio signal Aus at the output terminal 102. In one embodiment, the output current lo flowing through the output node 122 can be either a positive current that flows from the output node 122 to the load 15 or a negative current that flows back from the load 15 to the output node 122. As shown in Figure 1, the direction of the current lo flowing from the output node 122 to the load 15 is defined as positive.

In one embodiment, the power stage 12 is configured to provide the output voltage Vout via amplifying the pulse modulated signal PWM1. The high-side power switch 125 connects the output node 122 to the power supply voltage Vddp during when the high-side switch 125 maintains on, and the low-side power switch 126 connects the output node 122 to the power supply voltage Vssp during when the low-side power switch 126 maintains on. As a result, the output voltage Vout transitions between the power supply voltages Vddp and Vssp. The high-side power switch 125 and the low-side power switch 126 may comprise Metal Oxide Semiconductor Field Effect Transistor (MOSFET), Junction Field Effect Transistor (JFET), Insulated Gate Bipolar Transistor (IGBT), and other suitable transistors. In one embodiment, the first ends D1 and D2 are Drain, the second ends S1 and S2 are Source, and control ends G1 and G2 are Gate. In the embodiment of Figure 1, the power stage 12 further comprises drivers 127 and 128. The driver 127 is coupled to the control end G1 to drive the high-side power switch 125, and the driver 128 is coupled to the control end G2 to drive the low-side power switch 126.

The controller 13 is configured to receive the pulse modulated signal PWM1 and provide switching control signals Dr1 and Dr2 based on the pulse modulated signal PWM1 to control the high-side power switch 125 and the low-side power switch 126 respectively, e.g., turning on and turning off the high-side power switch 125 and the low-side power switch 126 alternately. In one embodiment, the controller 13 may be a programable digital control device, e.g., Complex Programmable Logic Device (CPLD), Field-Programmable Gate Array (FPGA), Microprogrammed Control Unit (MCU) and so on. In the embodiment of Figure 1, the driver 127 is configured to receive the switching control signal Dr1 and control the high-side power switch 125 based on the switching control signal Dr1, and the driver 128 is configured to receive the switching control signal Dr2 and control the low-side power switch 126 based on the switching control signal Dr2. In one embodiment, the controller 13 is configured to adaptively adjust a time interval between turning off one of the pair of power switches and turning on the other one of the pair of power switches based on the output current lo. For example, a time interval Dt1 between controlling the switching control signal Dr2 to turn off the low-side power switch 126 and controlling the switching control signal Dr1 to turn on the high-side power switch 125 could be adaptively adjusted based on the output current lo, and a time interval Dt2 between controlling the switching control signal Dr1 to turn off the high-side power switch 125 and controlling the switching control signal Dr2 to turn on the low-side power switch 126 could be adaptively adjusted based on the output current lo.

In one embodiment, in response to a rising transition of the output voltage Vout (e.g., transitioning from the power supply voltage Vssp to the power supply voltage Vddp), if the output current lo is negative and an absolute value of the output current lo is less than a time extension threshold (i.e., the output current lo flows from the load 15 to the pin 105 is below the time extension threshold), the controller 13 is configured to increase the time interval Dt1 to delay the activation of turning on the high-side power switch 125 after turning off the low-side power switch 126. Otherwise if the output current lo is positive or the absolute value of the output current lo is larger than the time extension threshold (i.e., the output current lo flows from the pin 105 to the load 15 or the output current lo flows from the load 15 to the pin 105 exceeds the time extension threshold), the time interval Dt1 equals a default time period. In one embodiment, in response to a falling transition of the output voltage Vout (e.g., transitioning from the power supply voltage Vddp to the power supply voltage Vssp), if the output current lo is positive and the absolute value of the output current lo is less than the time extension threshold (i.e., the output current lo flows from the pin 105 to the load 15 is below the time extension threshold), the controller 13 is configured to increase the time interval Dt2 to delay the activation of turning on the low-side power switch 126 after turning off the high-side power switch 125. Otherwise, if the output current lo is negative or the absolute value of the output current lo is larger than the time extension threshold (i.e., the output current lo flows from the load 15 to the pin 105 or the output current lo flows from the pin 105 to the load 15 exceeds the time extension threshold), the time interval Dt2 equals the default time period.

In the embodiment of Figure 1, the class-D audio amplifier 100 further comprises a current level detector 129 to provide a time-period extension signal Curd based on the output current lo. The current level detector 129 may be integrated in the IC 103. In one embodiment, the controller 13 is coupled to the current level detector 129 to receive the time-period extension signal Curd, and the controller 13 is configured to adjust the time interval Dt1 and the time interval Dt2 based on the time-period extension signal Curd. In one embodiment, when the time-period extension signal Curd indicates that the output current lo is negative and the absolute value of the output current lo is less than the time extension threshold, the controller 13 is configured to increase the time interval Dt1, e.g., from the default time period to a sum of the default time period and an extra time period. In one embodiment, when the time-period extension signal Curd indicates that the output current lo is positive and is less than the time extension threshold, the controller 13 is configured to increase the time interval Dt2, e.g., from the default time period to the sum of the default time period and the extra time period. Otherwise, the controller 13 is configured to control the time intervals Dt1 and Dt2 being equal to the default time period. In one embodiment, the default time period is zero. For example, once the switching control signal Dr1 becomes a first state (e.g., logic low) to turn off the high-side power switch 125, the switching control signal Dr2 will become a second state (e.g., logic high) to turn on the low-side power switch 126, and once the switching control signal Dr2 becomes the first state to turn off the low-side power switch 126, the switching control signal Dr1 will become the second state to turn on the high-side power switch 125. In another embodiment, the default time period may be longer than zero. In some examples, a voltage level between a high threshold voltage (e.g. 2V) and a voltage source (e.g. 3.3V) is considered as the logic high, a voltage level between zero voltage (0 V) and a low threshold voltage (e.g. 1V) is considered as the logic low.

In one embodiment, the current level detector 129 is further configured to provide an over current indication signal OC based on the output current lo. The controller 13 is coupled to the current level detector 129 to receive the over current indication signal OC. If the over current indication signal OC indicates that the absolute value of the output current lo is higher than an over current threshold, the controller 13 is configured to respond to the over current indication signal OC, for example but not limited to turn off at least one of the high-side power switch 125 and the low-side power switch 126.

In the embodiment of Figure 1, the class-D audio amplifier 100 further comprises a time period generator 124 to control the time intervals Dt1 and Dt2. The time period generator 124 may be integrated in the IC 103. In one embodiment, the time period generator 124 is coupled to the controller 13 to receive a set signal Settimer for injecting the extra time period and provide a time control signal CDT in response to the set signal Settimer and the extra time period. The time period generator 124 is configured to extend the time intervals Dt1 or Dt2 in response to the set signal Settimer.

The class-D audio amplifier proposed by embodiments of the present invention is configured to adaptively extend the time interval between turning off one of the pair of power switches and turning on the other one of the pair of power switches, so as to save idle power, e.g., power loss during when the absolute value of the output current lo is less than the time extension threshold. The inductor Lo continues the output current lo during the extended time interval, and the transition of the output voltage Vout between the power supply voltages Vddp and Vssp is established by the output current lo if it flows in a correct direction. For example, the output current lo flowing out of the output node 122 to the load 15 will establish the falling transition of the output voltage Vout, and the output current lo flowing into the output node 122 from the load 15 will establish the rising transition of the output voltage Vout.

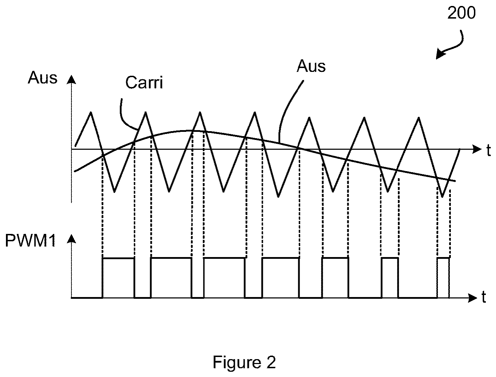

Figure 2 shows a timing diagram 200 of the pulse modulator 11 in accordance with an embodiment of the present invention. As shown in Figure 2, the pulse modulated signal PWM1 is generated via comparing the audio signal Aus with the carrier signal Carri. When the audio signal Aus is higher than the carrier signal Carri, the pulse modulated signal PWM1 is logic high, and when the audio signal Aus is lower than the carrier signal Carri, the pulse modulated signal PWM1 is logic low. A frequency of the carrier signal Carri determines a frequency of the pulse modulated signal PWM1. One with ordinary skill in the art should also understand that the logic high and the logic low of the pulse modulated signal PWM1 may be interchanged without detracting merits of the present invention.

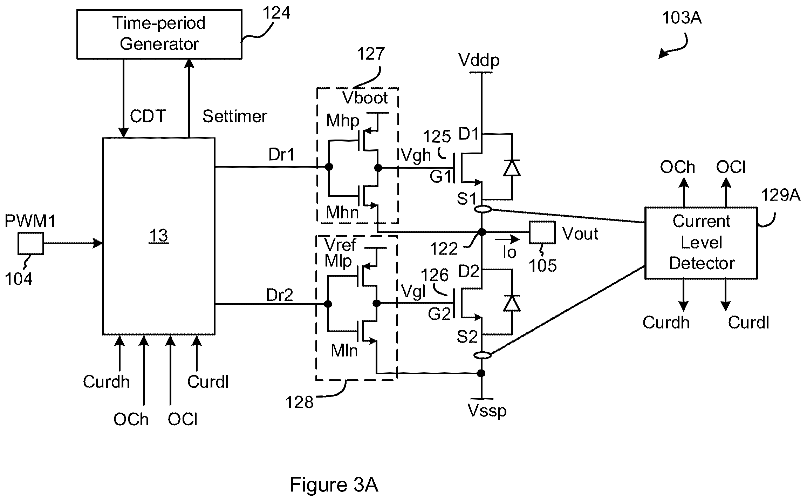

Figure 3A shows a schematic diagram of an IC 103A in accordance with an embodiment of the present invention. The IC 103A is a particular embodiment of the IC 103 of Figure 1.

In the embodiment of Figure 3A, the time-period extension signal Curd comprises a high-side extension signal Curdh and a low-side extension signal Curdl. The IC 103A has a current level detector 129A, which is configured to provide the high-side extension signal Curdh and the low-side extension signal Curdl based on the output current lo. In one embodiment, the current level detector 129A provides the high-side extension signal Curdh based on the output current lo during when the high-side power switch 125 is on and the low-side power switch 126 is off, and the current level detector 129A provides the low-side extension signal Curdl based on the output current lo during when the low-side power switch 126 is on and the high-side power switch 125 is off. The controller 13 is coupled to the current level detector 129A to receive the high-side extension signal Curdh and the low-side extension signal Curdl. The controller 13 is configured to adaptively adjust the time interval Dt2 based on the high-side extension signal Curdh, and adaptively adjust the time interval Dt1 based on the low-side extension signal Curdl. In the embodiment of Figure 3A, the overcurrent signal OC comprises a high-side overcurrent signal OCh and a low-side overcurrent signal OCI. In one embodiment, the current level detector 129A further provides the high-side overcurrent signal OCh to indicate if the current flowing though the high-side power switch 125 exceeds an over current threshold, provides the low-side overcurrent signal OCI to indicate if the current flowing though the low-side power switch 126 exceeds the over current threshold. In one embodiment, the over current threshold includes a high-side over current threshold and a low-side over current threshold. In one embodiment, when the high-side overcurrent signal OCh indicates that the current flowing through the high-side power switch 125 exceeds the high-side over current threshold, the controller 13 is configured to turn off the high-side power switch 125, and when the low-side overcurrent signal OCI indicates that the current flowing through the low-side power switch 126 exceeds the low-side over current threshold, the controller 13 is configured to turn off the low-side power switch 126. In one embodiment, the low-side over current threshold equals the high-side over current threshold.

In the embodiment of Figure 3A, the driver 127 comprises two switches Mhp and Mhn. A first end of the switch Mhp is coupled to a power supply Vboot, a second end of the switch Mhp and a first end of the switch Mhn are coupled together to provide a drive signal Vgh to drive the high-side power switch 125. A control end of the switch Mhp and a control end of the switch Mhn are coupled together to receive the switching control signal Dr1, the switches Mhp and Mhn are controlled by the switching control signal Dr1, and provide the drive signal Vgh based on the switching control signal Dr1. In one embodiment, the switch Mhp is P-type MOSFET (PMOS), and the switch Mhn is N-type MOSFET (NMOS). In the embodiment of Figure 3A, the driver 128 comprises two switches Mlp and MIn. A first end of the switch MIp is coupled to a power supply Vref, a second end of the switch MIp and a first end of the switch MIn are coupled together to provide a drive signal Vgl to drive the low-side power switch 126. A control end of the switch Mlp and a control end of the switch MIn are coupled together to receive the switching control signal Dr2, the switches Mlp and MIn are controlled by the switching control signal Dr2, and provide the drive signal Vgl based on the switching control signal Dr2. In one embodiment, the switch Mlp is PMOS, and the switch MIn is NMOS.

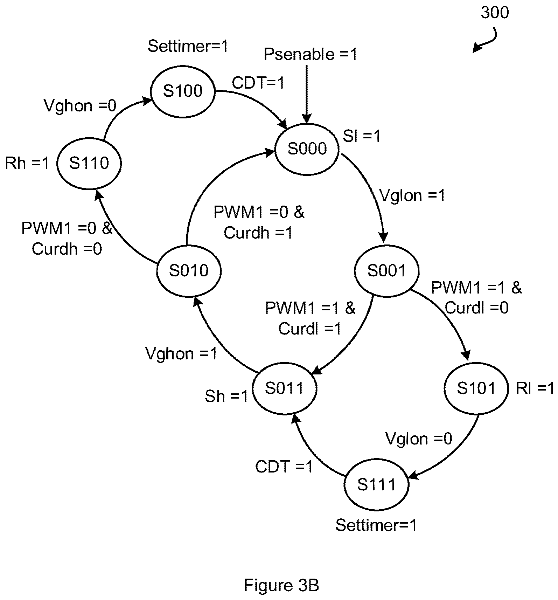

Figure 3B shows a state diagram 300 of the IC 103A in accordance with an embodiment of the present invention. In the embodiment shown in Figure 3B, the state diagram 300 has states S000, S001, S010, S011, S100, S101, S110, S111. One with ordinary skill in the art should understand that the state diagram of the IC 103A is not limited by the specific embodiment of Figure 3B.

At the state S000, after the IC 103A is enabled (e.g., an enable signal PSenable is logic high), a set signal SI becomes logic high (SI=1) to turn on the low-side power switch 126. Until an indicating signal Vglon indicates that the low-side power switch 126 is switched on (e.g., Vglon = 1), the IC 103A goes to the state S001. At the state S001, once the pulse modulated signal PWM1 is logic high (PWM1=1), the time interval Dt1 is determined whether to be extended based on the low-side extension signal Curdl. When the absolute value of the output current lo is larger than a low-side time extension threshold or the output current lo is positive, the low-side extension signal Curdl is set to logic high (Curdl=1), and the IC 103A goes to the state S011 to turn on the high-side power switch 125 without extending the time interval Dt1. When the absolute value of the output current lo is less than the low-side time extension threshold and the output current lo is negative (e.g., a current flows from the first end D2 to the second end S2 of the low-side power switch 126 is less than the low-side time extension threshold), the low-side extension signal CurdI is set to logic low (Curdl=0), and the IC 103A goes to the state S101 to extend the time interval Dt1. At the state S101, a reset signal RI becomes logic high (RI=1) to turn off the low-side power switch 126. Until the indicating signal Vglon indicates that the low-side power switch 126 is switched off (Vglon = 0), the IC 103A goes to the state S111. At the state S111, the set signal Settimer becomes logic high (Settimer =1), and the time-period generator 124 is configured to provide the extra time period (for example 50ns) to extend the time interval Dt1. Once the extended time interval Dt1 expires, the time control signal CDT becomes logic high (CDT = 1), the IC 103A goes to the state S011 to turn on the high-side power switch 125. At the state S011, a set signal Sh becomes logic high (Sh=1) to turn on the high-side power switch 125. Until an indicating signal Vghon indicates that the high-side power switch 125 is switched on (Vghon = 1), the IC 103A goes to the state S010.

At the state S010, once the pulse modulated signal PWM1 is logic low (PWM1=0), the time interval Dt2 is determined whether to be extended based on the high-side extension signal Curdh. In the embodiment shown in Figure 3B, when the absolute value of the output current lo is larger than a high-side time extension threshold or the output current lo is negative, the high-side extension signal Curdh is set to logic high (Curdh=1), and the IC 103A goes to the state S000 to turn on the low-side power switch 126 without extending the time interval Dt2. When the absolute value of the output current lo is less than the high-side time extension threshold and the output current lo is positive (e.g., a current flows from the first end D1 to the second end S1 of the high-side power switch 125 is less than the high-side time extension threshold), the high-side extension signal Curdh is set to logic low (Curdh=0), and the IC 103A goes to the state S110 to extend the time interval Dt2. At the state S110, a reset signal Rh becomes logic high (Rh=1) to turn off the high-side power switch 125. Until the indicating signal Vghon indicates that the high-side power switch 125 is switched off (Vghon = 0), the IC 103A goes to the state S100. At the state S100, the set signal Settimer becomes logic high (Settimer = 1), and the time-period generator 124 is configured to provide the extra time period (for example 50ns) to extend the time interval Dt2. Once the extended time interval Dt2 expires, the time control signal CDT becomes logic high (CDT = 1), the IC 103A goes to the state S000 to turn on the low-side power switch 126.

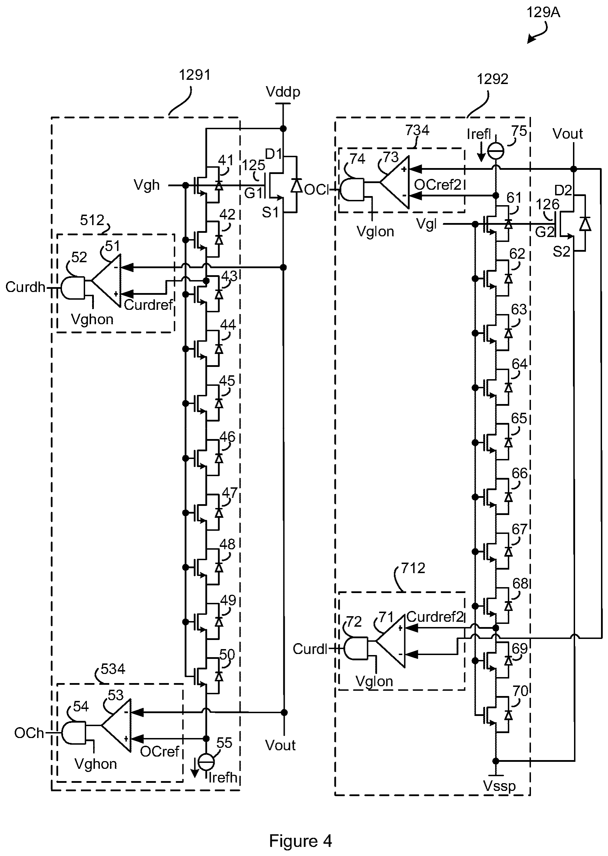

Figure 4 shows a schematic diagram of the current level detector 129A of Figure 3A in accordance with an embodiment of the present invention. As shown in Figure 4, the current level detector 129A comprises a high-side current detect circuit 1291 and a low-side current detect circuit 1292. The high-side current detect circuit 1291 provides the high-side extension signal Curdh and the high-side overcurrent signal OCh based on the output current lo during when the high-side power switch 125 is on, e.g., based on the current flowing through the high-side power switch 125, and the low-side current detect circuit 1292 provides the low-side extension signal Curdl and the low-side overcurrent signal OCI based on the output current lo during when the low-side power switch 126 is on, e.g., based on the current flowing through the low-side power switch 126. One with ordinary skill in the art should understand that the embodiment of Figure 4 is just an example of implementation of the current level detector 129A, and other suitable circuit could also be employed to measure the output current lo.

In the embodiment of Figure 4, the high-side current detect circuit 1291 comprises a plurality of transistors 41-50 coupled in series between the power supply voltage Vddp and a current source 55. The current source 55 provides a current Irefh flowing through the transistors 41-50. Each of the transistors 41-50 has a first end, a second end, and a control end coupled to the control end G1 of the high-side power switch 125, and each of the transistors 41-50 is turned on when the high-side power switch 125 is turned on. The first end of the transistor 41 is coupled to the power supply Vddp, the second end of the transistor 41 is coupled to the first end of the transistor 42, the second end of the transistor 42 is coupled to the first end of the transistor 43, and so forth. The second end of the transistor 50 is coupled to the current source 55. The high-side current detect circuit 1291 further comprises a comparison circuit 512 and a comparison circuit 534. When the high-side power switch 125 is on, the comparison circuit 512 is configured to provide the high-side extension signal Curdh via comparing a voltage across the high-side power switch 125 with a voltage across the transistors 41-42 and the comparison circuit 534 is configured to provide the high-side overcurrent signal OCh via comparing the voltage across the high-side power switch 125 with a voltage across the transistors 41-50. In the embodiment of Figure 4, the voltage across the transistors 41-42 generates a time extension reference Curdref, and the voltage across the transistors 41-50 generates an overcurrent reference OCref. The overcurrent reference OCref is higher than the time extension reference Curdref. In the embodiment of Figure 4, the overcurrent reference OCref may be five times of the time extension reference Curdref. One with ordinary skill in the art should understand that the scaling relationship between the time extension reference Curdref and the overcurrent reference OCref is not limited by Figure 4, e.g., the overcurrent reference OCref may be larger than or less than five times of the time extension reference Curdref.

In the embodiment of Figure 4, the comparison circuit 512 comprises a comparator 51 and an AND gate 52. An inverting terminal of the comparator 51 is coupled to the second end S1 of the high-side power switch 125, a non-inverting terminal of the comparator 51 is coupled to a second end of the transistor 42 and a first end of the transistor 43. An output terminal of the comparator 51 is coupled to a first input terminal of the AND gate 52, a second input terminal of the AND gate 52 is coupled to the indicating signal Vghon, and an output terminal of the AND gate 52 provides the high-side extension signal Curdh. In the embodiment of Figure 4, the comparison circuit 534 comprises a comparator 53 and an AND gate 54. An inverting terminal of the comparator 53 is coupled to the second end S1 of the high-side power switch 125, a non-inverting terminal of the comparator 53 is coupled to a second end of the transistor 50. An output terminal of the comparator 53 is coupled to a first input terminal of the AND gate 54, a second input terminal of the AND gate 54 is coupled to the indicating signal Vghon, and an output terminal of the AND gate 54 provides the high-side overcurrent signal OCh.

In the embodiment of Figure 4, the low-side current detect circuit 1292 comprises a plurality of transistors 61-70 coupled in series between the power supply voltage Vssp and a current source 75. The current source 75 provides a current Irefl flowing through the transistors 61-70. Each of the transistors 61-70 has a first end, a second end, and a control end coupled to the control end G2 of the low-side power switch 126, and each of the transistors 61-70 is turned on when the low-side power switch 126 is turned on. The first end of the transistor 61 is coupled to the current source 75, the second end of the transistor 61 is coupled to the first end of the transistor 62, the second end of the transistor 62 is couple to the first end of the transistor 63, and so forth. The second end of the transistor 70 is coupled to the power supply voltage Vssp and the second end of the low-side power switch 126. The low-side current detect circuit 1292 further comprises a comparison circuit 712 and a comparison circuit 734. When the low-side power switch 126 is on, the comparison circuit 712 is configured to provide the low-side extension signal Curdl via comparing a voltage across the low-side power switch 126 with a voltage across the transistors 69-70. When the low-side power switch 126 is on, the comparison circuit 734 is configured to provide the overcurrent signal OCI via comparing the voltage across the low-side power switch 126 with a voltage across the transistors 61-70. In the embodiment of Figure 4, the voltage across the transistors 69-70 generates a time extension reference Curdref2, and the voltage across the transistors 61-70 generates an overcurrent reference OCref2. The overcurrent reference OCref2 is higher than the time extension reference Curdref2. In the embodiment of Figure 4, the overcurrent reference OCref2 may be five times the time extension reference Curdref2. One with ordinary skill in the art should understand that the scaling relationship between the time extension reference Curdref2 and the overcurrent reference OCref2 is not limited by Figure 4.

In the embodiment of Figure 4, the comparison circuit 712 comprises a comparator 71 and an AND gate 72. An inverting terminal of the comparator 71 is coupled to the first end D2 of the low-side power switch 126, a non-inverting terminal of the comparator 71 is coupled to the second end of the transistor 68 and the first end of the transistor 69. An output terminal of the comparator 71 is coupled to a first input terminal of an AND gate 72, a second input terminal of an AND gate 72 is coupled to the indicating signal Vglon, and an output terminal of the AND gate 72 provides the low-side extension signal Curdl. In the embodiment of Figure 4, the comparison circuit 734 comprises a comparator 73 and an AND gate 74. An inverting terminal of the comparator 73 is coupled to the first end D2 of the low-side power switch 126, a non-inverting terminal of the comparator 73 is coupled to the first end of the transistor 61. An output terminal of the comparator 73 is coupled to a first input terminal of the AND gate 74, a second input terminal of the AND gate 74 is coupled to the indicating signal Vglon, and an output terminal of the AND gate 74 provides the overcurrent signal OCI.

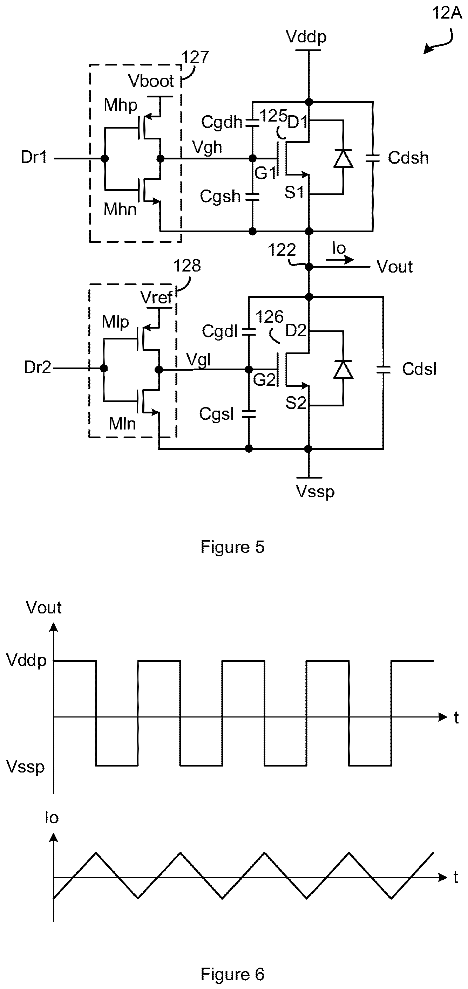

Figure 5 shows a schematic diagram of a power stage 12A with parasitic capacitances in accordance with an embodiment of the present invention. As shown in Figure 5, the high-side power switch 125 has a parasitic capacitor Cgsh between the control end G1 and the second end S1 of the high-side power switch 125, a parasitic capacitor Cgdh between the first end D1 and the control end G1 of the high-side power switch 125, and a parasitic capacitor Cdsh between the first end D1 and the second end S1 of the high-side power switch 125. The low-side power switch 126 has a parasitic capacitor Cgsl between the control end G2 and the second end S2 of the low-side power switch 126, a parasitic capacitor Cgdl between the first end D2 and the control end G2 of the low-side power switch 126, and a parasitic capacitor Cdsl between the first end D2 and the second end S2 of the low-side power switch 126.

All parasitic capacitances, as shown in Figure 5, need to be charged or discharged during the transition of the output voltage Vout. The gate drivers 127 and 128 charge and discharge the control end G1 of the high-side power switch 125 and the control end G2 of the low-side power switch 126, respectively. When the gate driver 127 actively discharges the control end G1 of the high-side power switch 125 or the gate driver 128 actively discharges the control end G2 of the low-side power switch 126 during the transition of the output voltage Vout, it will cost extra energy. For example, the energy stored in the parasitic capacitor Cdsh is dissipated by the low-side power switch 126, the energy stored in the parasitic capacitor Cdsl is dissipated by the high-side power switch 125, all the energy stored in the Cgdh and Cgsh are dissipated by the gate driver 127, and all the energy stored in the Cgdl and Cgsl are dissipated by the gate driver 128.

Embodiments of the present invention help to reduce power loss via adaptively adjusting the time intervals Dt1 and Dt2 without the need to detect any zero voltage switching (ZVS) condition by high speed comparators. Traditionally, the high-side power switch 125 or the low-side power switch 126 can only be turned on when the ZVS condition is detected, causing a slowdown in switching behavior during hard switching, and resulting in an increased reverse recovery problem. In embodiments of the present invention, extending the time interval Dt1 helps reduce idle power at the rising transition of the output voltage Vout with small negative output current lo, and extending the time interval Dt2 helps reduce idle power at the falling transition of the output voltage Vout with small positive output current lo.

Figure 6 shows a timing diagram indicating the output current lo with 50% modulation in accordance with an embodiment of the present invention. In an embodiment of the present invention, the output filter 14 is connected to the output node 122, and the inductor Lo filters the output current lo, as shown in Figure 1, resulting in a triangular-shaped current with 50% modulation as shown in Figure 6. In the example of Figure 6, the output current lo has a ripple that flows in and out of the output node 122 without duty cycle modulation for illustration. The positive output current lo flows out of the output node 122 and the negative output current lo flows into the output node 122. The triangle-shaped output current lo changes sign between the transitions edge of the output voltage Vout. However, with a high duty cycle modulation, this is no longer the case. The output current lo can exceed the ripple current and remains unidirectional. The negative output current lo tends to speed up the rising transition of the output voltage Vout and the positive current lo tends to speed up the falling transition of the output voltage Vout, e.g., this scenario is called soft switching. Soft switching happens at both edges with a block pulse of 50% duty cycle when a LC output filter is used while cost less energy of the gate drivers. On the contrary, the negative output current lo tends to resist the falling transition edge, and the positive current lo tends to resist the rising transition edge, e.g., this scenario is called hard switching.

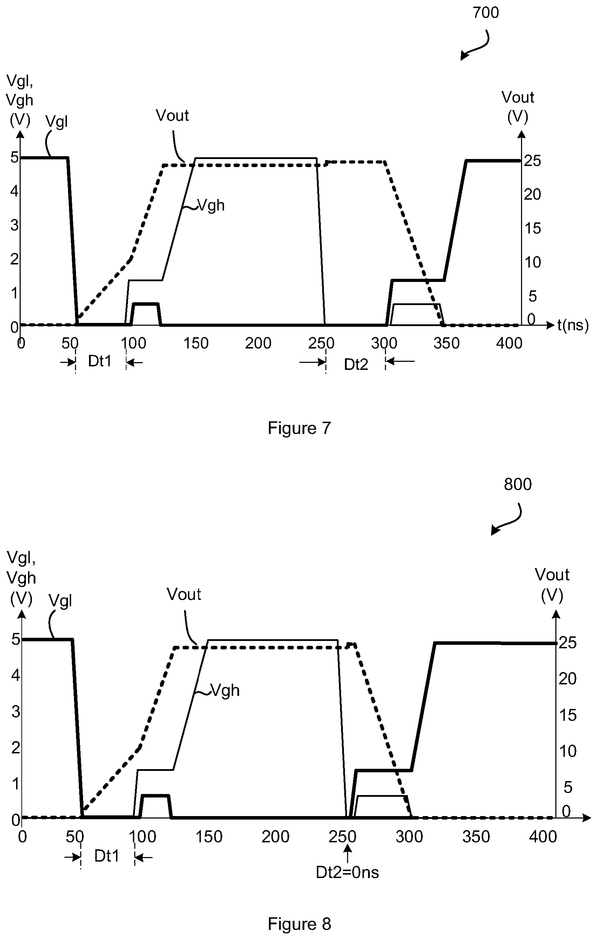

Figures 7-11 show timing diagrams of the power stage 12A in accordance with an embodiment of the present invention. In the example of Figures 7-11, the parasitic capacitors Cgdh and Cgdl are constant for simplification, and the waveforms shown in Figures 7-11 are ideal. However, one with ordinary skill in the art should understand that the parasitic capacitor Cgdh may be dependent on a drain-source voltage across the high-side power switch 125, and the parasitic capacitor Cgdl may be dependent on a drain-source voltage across the low-side power switch 126.

Figure 7 shows a timing diagram 700 of the power stage 12A with small negative output current lo in accordance with an embodiment of the present invention. In the embodiment of Figure 7, the output current lo is -30mA, and the default time period is 0ns as one example. In the embodiment of Figure 7, the time interval Dt1 is extended to 50ns, and the output current lo flowing into the power stage 12A helps setup the rising transition of the output voltage Vout during the time interval Dt1. Since the time interval Dt1 is extended, the idle dissipation is reduced. The drive signals Vgh and Vgl are fixed to 0V during the time interval Dt1 by switching on the transistors Mhn and MIn. The parasitic capacitors Cgdl and the Cdsl are charged by the output current lo and the parasitic capacitors Cgdh and Cdsh are discharged by the output current lo. The output current lo contributes to speed up the output voltage Vout transition and this contribution is called soft switching. At the moment of 100ns, the switching control signal Dr1 becomes logic high to turn on the high-side power switch 125, the drive signal Vgh increases, and then the high-side power switch 125 takes over the edge transition. The edge transition can also be completed with longer time interval Dt1 or larger output current lo, e.g., the high-side power switch 125 is turned on when the voltage across the first end D1 and the second end S1 falls to near zero volts.

As shown in Figure 7, hard switching happens at the falling edge transition of the output voltage Vout from the moment between 300ns to 350ns. The -30mA output current lo tends to resist the falling edge transition of the output voltage Vout. The falling edge transition of the output voltage Vout is completely made by the driver 128. During the time interval Dt2 (from the moment between 250ns to 300ns), no transition of the output voltage Vout occurs. The output current lo will immediately flow through a body diode of the high-side power switch 125 that is just switched off. In the embodiment of Figure 7, the time interval Dt2 is extended to 50ns. However, the extended Dt2 has no contribution to reducing the idle dissipation but delays the transition of the output voltage Vout. Once the switching control signal Dr2 becomes logic high to turn on the low-side power switch 126, the drive signal Vgl increases, and then the falling transition of the output voltage Vout will take place. As shown in Figure 7, it is unnecessary to extend the time interval Dt2.

Figure 8 shows a timing diagram 800 of the power stage 12A with small negative output current lo in accordance with an embodiment of the present invention. In one example, the output current lo of Figure 8 is -30mA and the default time period is 0ns. Different with Figure 7, in the embodiment of Figure 8, the time interval Dt2 is not extended (e.g., equals the default time period 0ns).

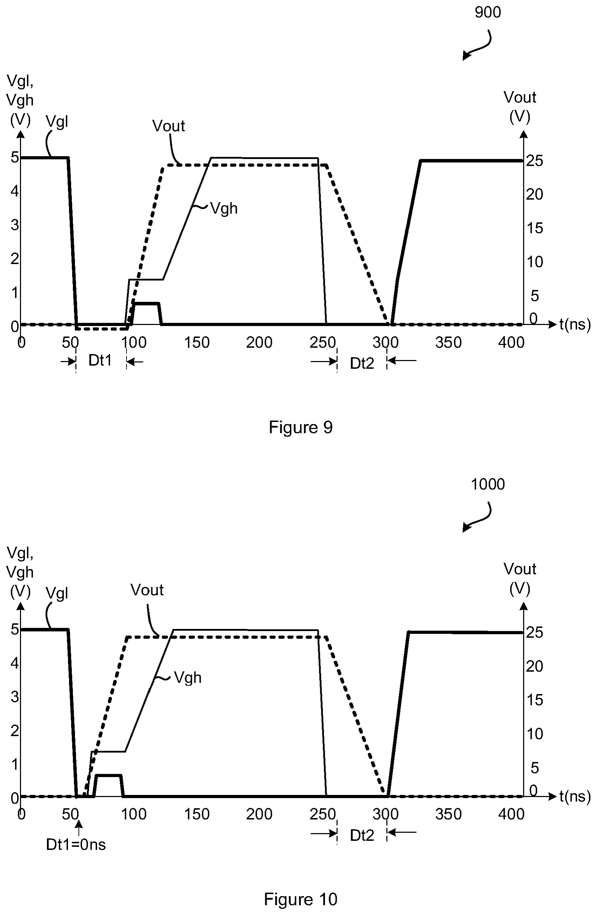

Figure 9 shows a timing diagram 900 of the power stage 12A with small positive output current lo in accordance with an embodiment of the present invention. In one example, the output current lo of Figure 9 is 60mA and the default time period is 0ns. In the embodiment of Figure 9, the time interval Dt2 is extended to 50ns, and the output current lo flows out of the power stage 12A to help setup falling transition of the output voltage Vout during the time interval Dt2. As shown in Figure 9, the output voltage Vout decreases to zero volts during the time interval Dt2, then the low-side power switch 126 is turned on after the time interval Dt2. There is no voltage drop over the low-side power switch 126, and the low-side power switch 126 is switched on with zero voltage switching. The only energy it takes is recharging the gate G2 of the low-side power switch 126. Charging and recharging of the parasitic capacitors Cgdh and Cdsh of the high-side power switch 125 are done by the output current lo, and charging and recharging of the parasitic capacitors Cgdl and Cdsl of the low-side power switch 126 are done by the output current lo.

Since the time interval Dt2 is extended, the idle dissipation is reduced. In the embodiment of Figure 9, the time interval Dt1 is extended to 50ns. However, the extended Dt1 has no contribution to reducing the idle dissipation but delays the transition of the output voltage Vout.

Figure 10 shows a timing diagram 1000 of the power stage 12A with small positive output current lo in accordance with an embodiment of the present invention. In one example, the output current lo of Figure 10 is 60mA and the default time period is 0ns. Different with Figure 9, in the embodiment of Figure 10, the time interval Dt1 is not extended (e.g., 0ns).

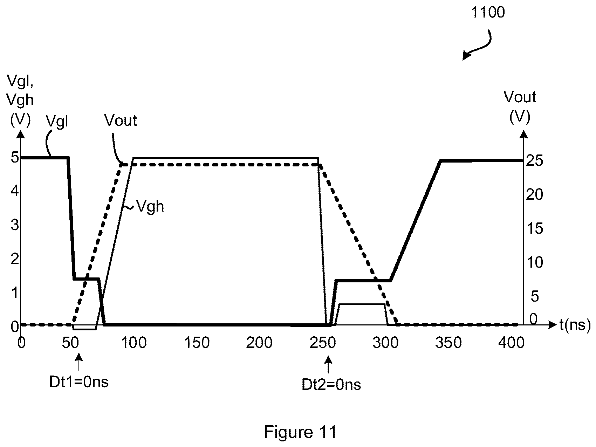

Figure 11 shows a timing diagram 1100 of the power stage 12A with large negative output current lo in accordance with an embodiment of the present invention. In one example, the output current lo of Figure 11 is -1A and the default time period is 0ns. In the embodiment of Figure 11, both of the time intervals Dt1 and Dt2 are not extended (e.g., equals to the default time period 0ns).

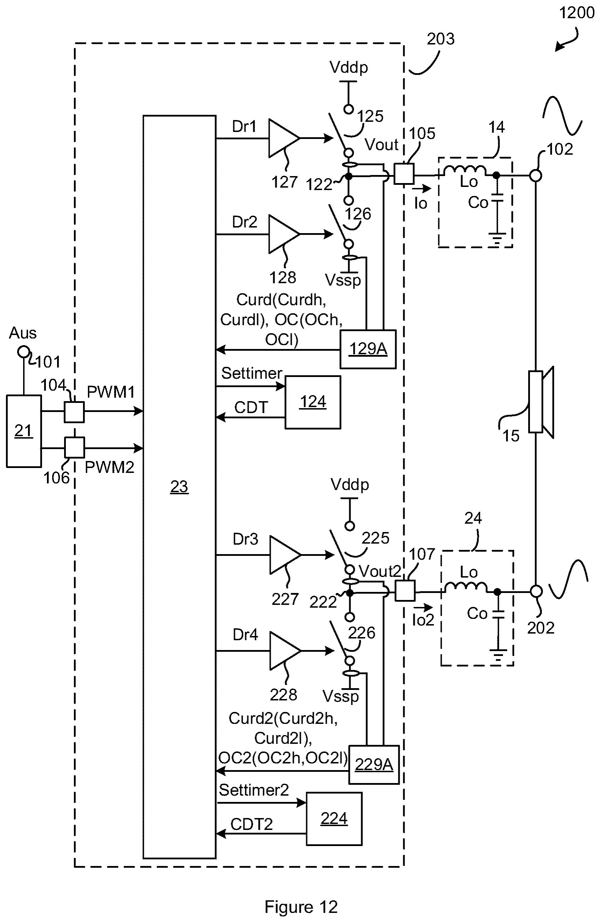

Figure 12 shows a block diagram of a class-D audio amplifier 1200 in accordance with an embodiment of the present invention. The class-D audio amplifier 1200 has the input terminal 101, the output terminal 102, an output terminal 202, a pulse modulator 21, an IC 203, the output filter 14, and an output filter 24. The input terminal 101 is configured to receive the audio signal Aus, the output terminal 102 is coupled to one end of the load 15 to provide a reconstructed audio signal, and the output terminal 202 is coupled to the other end of the load 15 to provide an inverted reconstructed audio signal. The pulse modulator 21 is configured to provide pulse modulated signals PWM1-PWM2. In one embodiment, the pulse modulated signal PWM2 is inverted from the pulse modulated signal PWM1. In another embodiment, the pulse modulator 21 also could receive two audio signals and generates pulse modulated signals PWM1-PWM2 respectively based on the two audio signals.

As shown in Figure 12, the IC 203 has pins 104-107. The pin 104 is configured to receive the pulse modulated signal PWM1, and the pin 106 is configured to receive the pulse modulated signal PWM2. The pin 105 is configured to provide the output voltage Vout, and the pin 107 is configured to provide an output voltage Vout2. The IC 203 further comprises a first power stage formed by the pair of the power switches 125-126 and gate drivers 127-128, a second power stage formed by a pair of power switches 225-226 and gate drivers 227-228, and a controller 23. Each pair of the power switches 125-126, and 127-128 are coupled in series between the power supply voltages Vddp and Vssp. The power switches 125 and 126 form the output node 122 which is coupled to the pin 105 to provide the output voltage Vout, and the power switches 225 and 226 form the output node 222 which is coupled to the pin 107 to provide the output voltage Vout2.

In the embodiment of Figure 12, the controller 23 is configured to receive the pulse modulated signals PWM1-PWM2, provide the switching control signals Dr1-Dr2 based on the pulse modulated signal PWM1, and provide the switching control signals Dr3-Dr4 based on the pulse modulated signal PWM2. The switching control signals Dr1-Dr2 are configured to turn on and turn off the power switches 125-126 alternately to transition the output voltage Vout between the power supply voltages Vddp and Vssp. The switching control signals Dr3-Dr4 are configured to turn on and turn off the power switches 225-226 alternately to transition the output voltage Vout2 between the power supply voltages Vddp and Vssp. In one embodiment, the controller 23 is configured to adaptively adjust the time interval between turning off one of the power switches 125-126 and turning on the other one of the power switches 125-126 based on the output current lo flowing through the pin 105, and the controller 23 is configured to adaptively adjust a time interval between turning off one of the power switches 225-226 and turning on the other one of the power switches 225-226 based on an output current lo2 flowing through the pin 107.

In the embodiment of Figure 12, the IC 203 further comprises the time-period generator 124 coupled to the controller 23 to receive the set signal Settimer and provide the time control signal CDT as described above. Same as shown in Figures 3A-3B, the time-period generator 124 is configured to extend the time interval between turning off one of the power switches 125-126 and turning on the other one of the power switches 125-126 in response to the set signal Settimer and the extra time period. In the embodiment of Figure 12, the IC 203 further comprises a time-period generator 224 coupled to the controller 23 to receive a set signal Settimer2 and provide a time control signal CDT2. Similar with the time-period generator 124, the time-period generator 224 is configured to extend the time interval between turning off one of the power switches 225-226 and turning on the other one of the power switches 225-226 in response to the set signal Settimer2 and the extra time period. For example, a time interval Dt3 between controlling the switching control signal Dr4 to turn off the low-side power switch 226 and controlling the switching control signal Dr3 to turn on the high-side power switch 225 could be adaptively adjusted based on the output current Io2, and a time interval Dt4 between controlling the switching control signal Dr3 to turn off the high-side power switch 225 and controlling the switching control signal Dr4 to turn on the low-side power switch 226 could be adaptively adjusted based on the output current lo2. In one embodiment, in response to a rising transition of the output voltage Vout2 (e.g., transitioning from the power supply voltage Vssp to the power supply voltage Vddp), if the output current Io2 is negative (i.e., flows from the load 15 to the output node 222), and an absolute value of the output current Io2 is less than the time extension threshold, the controller 23 is configured to increase the time interval Dt3 (e.g., from the default time period to the sum of the default time period and the extra time period) to delay the activation of turning on the high-side power switch 225 after turning off the low-side power switch 226, otherwise if the output current Io2 is positive or the absolute value of the output current lo2 is larger than the time extension threshold, the time interval Dt3 equals the default time period. In one embodiment, in response to a falling transition of the output voltage Vout2 (e.g., transitioning from the power supply voltage Vddp to the power supply voltage Vssp), if the output current Io2 is positive (i.e., flows from the output node 222 to the load 15), and the absolute value of the output current Io2 is less than the time extension threshold, the controller 23 is configured to increase the time interval Dt4 (e.g., from the default time period to the sum of the default time period and the extra time period) to delay the activation of turning on the low-side power switch 226 after turning off the high-side power switch 225, otherwise if the output current Io2 is negative or the absolute value of the output current Io2 is larger than the time extension threshold, the time interval Dt4 equals the default time period.

In the embodiment of Figure 12, the IC 203 comprises the current level detector 129A configured to detect the output current lo and provide the time-period extension signal Curd, including the high-side extension signal Curdh and the low-side extension signal Curdl based on the output current lo. Same as shown in Figure 3A, the current level detector 129A provides the high-side extension signal Curdh based on the output current lo during when the high-side power switch 125 is on and the low-side power switch 126 is off, and the current level detector 129A provides the low-side extension signal Curdl based on the output current lo during when the low-side power switch 126 is on and the high-side power switch 125 is off. The controller 23 is coupled to the current level detector 129A to receive the high-side extension signal Curdh and the low-side extension signal Curdl. The controller 23 is configured to adaptively adjust the time interval Dt2 based on the high-side extension signal Curdh, and adaptively adjust the time interval Dt1 based on the low-side extension signal Curdl. In one embodiment, the current level detector 129A is further configured to provide the overcurrent signal OC based on the output current lo. The overcurrent signal OC includes the high-side overcurrent signal OCh and a low-side overcurrent signal OCI. In one embodiment, when the high-side overcurrent signal OCh indicates that the current flowing through the high-side power switch 125 exceeds the high-side over current threshold, the controller 23 is configured to turn off the high-side power switch 125, and when the low-side overcurrent signal OCI indicates that the current flowing through the low-side power switch 126 exceeds the low-side over current threshold, the controller 23 is configured to turn off the low-side power switch 126. In the embodiment of Figure 12, the IC 203 comprises a current level detector 229A configured to detect the output current lo2 and provide a time-period extension signal Curd2, including a high-side extension signal Curd2h and a low-side extension signal Curd2I. Similarly with the current level detector 129A, the current level detector 229A provides the high-side extension signal Curd2h based on the output current Io2 during when the high-side power switch 225 is on and the low-side power switch 226 is off, and the current level detector 229A provides the low-side extension signal Curd2I based on the output current Io2 during when the low-side power switch 226 is on and the high-side power switch 225 is off. The controller 23 is coupled to the current level detector 229A to receive the high-side extension signal Curd2h and the low-side extension signal Curd2I. The controller 23 is configured to adaptively adjust the time interval Dt4 based on the high-side extension signal Curd2h, and adaptively adjust the time interval Dt3 based on the low-side extension signal Curd2I. Similarly with the current level detector 129A, the current level detector 229A is further configured to provide an overcurrent signal OC2 based on the output current Io2. The overcurrent signal OC2 includes the high-side overcurrent signal OC2h and a low-side overcurrent signal OC2I. In one embodiment, the current level detector 229A is configured to provide the high-side overcurrent signal OC2h to indicate if the current flowing though the high-side power switch 225 is higher than the high-side over current threshold, and is configured to provide the overcurrent signal OC2I to indicate if the current flowing though the low-side power switch 226 is higher than the low-side over current threshold. In one embodiment, when the high-side overcurrent signal OC2h indicates that the current flowing through the high-side power switch 225 exceeds the high-side over current threshold, the controller 23 is configured to turn off the high-side power switch 225, and when the low-side overcurrent signal OC2I indicates that the current flowing through the low-side power switch 226 exceeds the low-side over current threshold, the controller 23 is configured to turn off the low-side power switch 226. In one embodiment, detailed circuit structure of the current level detector 229A is similar to the current level detector 129A shown in Figure 4, and is not shown for clarity.

In one embodiment, in response to the absolute value of the output current lo flowing into the pin 105 from the load 15 being lower than the time extension threshold, the time interval Dt1 between turning off the power switch 126 and turning on the power switch 125 is extended, and in response to the output current lo flowing from the pin 105 to the load 15 being lower than the time extension threshold, the time interval Dt2 between turning off the power switch 125 and turning on the power switch 126 is extended. In one embodiment, in response to the output current lo2 flowing into the pin 107 from the load 15 being lower than the time extension threshold, the time interval Dt3 between turning off the power switch 226 and turning on the power switch 225 is extended, and in response to the output current lo2 flowing from the pin 107 to the load 15 being lower than the time extension threshold, the time interval Dt4 between turning off the power switch 225 and turning on the power switch 226 is extended.

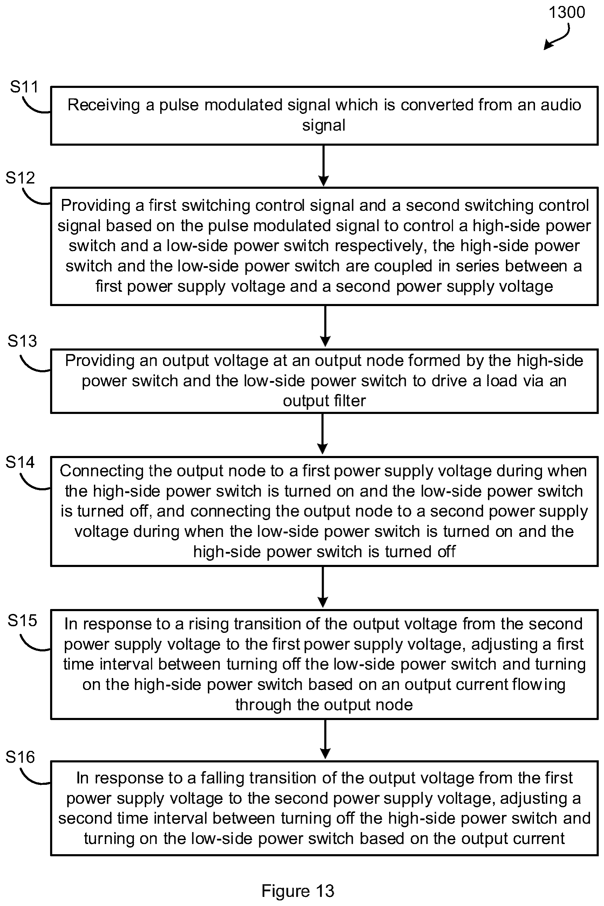

Figure 13 illustrates a control method 1300 of a class-D audio amplifier in accordance with an embodiment of the present invention. The control method 1300 has steps S11-S16.

At the step S11, receiving a pulse modulated signal which is converted from an audio signal. At the step S12, providing a first switching control signal and a second switching control signal based on the pulse modulated signal to control a high-side power switch and a low-side power switch respectively, the high-side power switch and the low-side power switch are coupled in series between a first power supply voltage and a second power supply voltage. At the step S13, providing an output voltage at an output node formed by the high-side power switch and the low-side power switch to drive a load via an output filter. At the step S14, connecting the output node to a first power supply voltage during when the high-side power switch is turned on and the low-side power switch is turned off, and connecting the output node to a second power supply voltage during when the low-side power switch is turned on and the high-side power switch is turned off. At the step S15, in response to a rising transition of the output voltage from the second power supply voltage to the first power supply voltage, adjusting a first time interval between turning off the low-side power switch and turning on the high-side power switch in response to an output current flowing through the output node. And at the step S16, in response to a falling transition of the output voltage from the first power supply voltage to the second power supply voltage, adjusting a second time interval between turning off the high-side power switch and turning on the low-side power switch in response to the output current.

In one embodiment, adjusting the first time interval comprises extending the first time interval when the output current flowing into the output node from the load is lower than a time extension threshold. In one embodiment, adjusting the first time interval further comprises maintaining the first time interval at a default time period when 1) the output current flows from the output node to the load or 2) the output current flowing into the output node from the load exceeds the time extension threshold.

In one embodiment, adjusting the second time interval comprises extending the second time when the output current flowing from the output node to the load is lower than the time extension threshold. In one embodiment, adjusting the second time interval further comprises maintaining the second time interval at a default time period when 1) the output current flows into the output node from the load or 2) the output current flowing from the output node to the load exceeds the time extension threshold.

In one embodiment, the control method 1300 further comprises providing a high-side extension signal based on the output current during when the high-side power switch is on and the low-side power switch is off, providing a low-side extension signal based on the output current during when the low-side power switch is on and the high-side power switch is off, and adjusting the second time interval based on the high-side extension signal and adjusting the first time interval based on the low-side extension signal.

Note that in the control method 1300 described above, the box functions may also be implemented with different orders as shown in Figure 13. Two successive box functions may be executed meanwhile, or sometimes the box functions may be executed in a reverse order.

Consequently, many modifications and variations of the present invention are possible in light of the above teachings. It is therefore to be understood that within the scope of the appended claims the invention may be practiced otherwise than as specifically described. It should be understood, thus, that the foregoing disclosure relates only to a preferred embodiment (or embodiments) of the invention and that numerous modifications may be made therein without departing from the spirit and the scope of the invention as set forth in the appended claims. Various modifications are contemplated, and they obviously will be resorted to by those skilled in the art without departing from the spirit and the scope of the invention as hereinafter defined by the appended claims as only a preferred embodiment(s) thereof has been disclosed.

## Claims

1. An integrated circuit (103) for a class-D audio amplifier (100), comprising:
a first pin (104) configured to receive a pulse modulated signal (PWM1);
a second pin (105) configured to provide an output voltage (Vout) via amplifying the pulse modulated signal (PWM1), wherein the output voltage (Vout) is used to drive a load (15) via an output filter (14);
a power stage (12) comprising a high-side power switch (125) and a low-side power switch (126), wherein a first end of the high-side power switch (D1) is coupled to a first power supply voltage (Vddp), a second end of the high-side power switch (S1) is coupled to a first end of the low-side power switch (D2) to form an output node, a second end of the low-side power switch (S2) is coupled to a second power supply voltage (Vssp), and the output node (122) is coupled to the second pin (105) to provide the output voltage (Vout); and
a controller (13) coupled to the first pin (104) to receive the pulse modulated signal (PWM1) and provide a first (Dr1) and a second (Dr2) switching control signals based on the pulse modulated signal (PWM1), wherein the first (Dr1) and second (Dr2) switching control signals are configured to turn on the high-side power switch (125) and the low-side power switch (126) alternately, to transition the output voltage (Vout) between the first power supply voltage (Vddp) and the second power supply voltage (Vssp); wherein
the controller (13) is configured to extend a first time interval (Dt1) between turning off the low-side power switch (126) and turning on the high-side power switch (125) when an output current (lo) flowing into the second pin (105) from the load (15) is below a time extension threshold; and wherein
the controller (13) is configured to extend a second time interval (Dt2) between turning off the high-side power switch (125) and turning on the low-side power switch (126) when the output current (lo) flowing from the second pin (105) to the load (15) is below the time extension threshold.

2. The integrated circuit (103) of claim 1, wherein the controller (13) is configured to maintain the first time interval (Dt1) at a default time period when 1) the output current (lo) flows from the second pin (105) to the load (15) or 2) the output current (lo) flowing into the second pin (105) from the load (15) exceeds the time extension threshold.

3. The integrated circuit (103) of claim 1, wherein the controller (13) is configured to maintain the second time interval (Dt2) at a default time period when 1) the output current (lo) flows into the second pin (105) from the load (15) or 2) the output current (lo) flowing from the second pin (105) to the load (15) exceeds the time extension threshold.

4. The integrated circuit (103) of claim 1, further comprising:
a time-period generator (124) coupled to the controller (13), wherein the time-period generator (124) is configured to generate an extra time period to extend the first time interval (Dt1) and the second time interval (Dt2).

5. The integrated circuit (103) of claim 1, further comprising:
a current level detector (129) coupled to the controller (13) to provide a high-side extension signal (Curdh) and a low-side extension signal (Curdl), wherein the high-side extension signal (Curdh) is provided based on the output current (lo) during when the high-side power switch (125) is on and the low-side power switch (126) is off, and the low-side extension signal (Curdl) is provided based on the output current (lo) during when the low-side power switch (126) is on and the high-side power switch (125) is off; wherein
the controller (13) is configured to extend the second time interval (Dt2) in response to the high-side extension signal (Curdh), and to extend the first time interval (Dt1) in response to the low-side extension signal (Curdl).

6. The integrated circuit (103) of claim 5, wherein the current level detector (129) comprises:
a first plurality of transistors (41-50) coupled in series between the first power supply voltage (Vddp) and a first current source (55), each of the first plurality of transistors (41-50) has a control end coupled to a control end (G1) of the high-side power switch (125);
a second plurality of transistors (61-70) coupled in series between the second power supply (Vssp) voltage and a second current source (75), each of the second plurality of transistors (61-70) has a control end coupled to a control end (G2) of the low-side power switch (126);
a first comparison circuit (512) configured to provide the high-side extension signal (Curdh) via comparing a voltage across the high-side power switch (125) with a voltage across a first part of the first plurality of transistors (41-42); and
a second comparison circuit (712) configured to provide the low-side extension signal (Curdl) via comparing a voltage across the low-side power switch (126) with a voltage across a first part of the second plurality of transistors (69-70).

7. The integrated circuit (103) of claim 6, wherein the current level detector (129) further comprises:
a third comparison circuit (534) configured to provide a high-side overcurrent signal (OCh) via comparing the voltage across the high-side power switch (125) with a voltage across a second part of the first plurality of transistors (41-50), to indicate if a current flowing through the high-side power switch (125) exceeds a high-side over current threshold; and
a fourth comparison circuit (734) configured to provide a low-side overcurrent signal (OCI) via comparing the voltage across the low-side power switch (126) with a voltage across a second part of the second plurality of transistors (61-70), to indicate if a current flowing through the low-side power switch (126) exceeds a low-side over current threshold.

8. An integrated circuit (203) for a class-D audio amplifier (1200), comprising:
a first pin (104) configured to receive a first pulse modulated signal (PWM1);
a second pin (106) configured to receive a second pulse modulated signal (PWM2);
a third pin (105) configured to provide a first output voltage (Vout) via amplifying the first pulse modulated signal (PWM1), wherein the third pin (105) is configured be coupled to a first end of a load (15) via a first output filter (14);
a fourth pin (107) configured to provide a second output voltage (Vout2) via amplifying the second pulse modulated signal (PWM2), wherein the fourth pin (107) is configured be coupled to a second end of the load (15) via a second output filter (24);
a first power stage comprising a first high-side power switch (125) and a first low-side power switch (126) coupled in series between a first power supply voltage (Vddp) and a second power supply voltage (Vssp), wherein the first high-side power switch (125) is coupled to the first low-side power switch (126) to form a first output node (122), and the first output node (122) is coupled to the third pin (105);
a second power stage comprising a second high-side power switch (225) and a second low-side power switch (226) coupled in series between the first power supply voltage (Vddp) and the second power supply voltage (Vssp), wherein the second high-side power switch (225) is coupled to the second low-side power switch (226) to form a second output node (222), and the second output node (222) is coupled to the fourth pin (107); and
a controller coupled (23) to the first pin (104) to receive the first pulse modulated signal (PWM1) and coupled to the second pin (106) to receive the second pulse modulated signal (PWM2), and configured to provide a first (Dr1) and a second (Dr2) switching control signals based on the first pulse modulated signal (PWM1), and provide a third (Dr3) and fourth (Dr4) switching control signals based on the second pulse modulated signal (PWM2), wherein the first (Dr1) and second (Dr2) switching control signals are configured to turn on the first high-side power switch (125) and the first low-side power switch (126) alternately, the third (Dr3) and fourth (Dr4) switching control signals are configured to turn on the second high-side power switch (225) and the second low-side power switch (226) alternately; wherein
the controller (23) is configured to adjust a first time interval (Dt1) between turning off the first low-side power switch (126) and turning on the first high-side power switch (125) and adjust a second time interval (Dt2) between turning off the first high-side power switch (125) and turning on the first low-side power switch (126) in response to a first output current (lo) flowing through the third pin (105), and the controller (23) is configured to adjust a third time interval (Dt3) between turning off the second low-side power switch (226) and turning on the second high-side power switch (225) and adjust a fourth time interval (Dt4) between turning off the second high-side power switch (225) and turning on the second low-side power switch (226) in response to a second output current (lo2) flowing through the fourth pin (107).

9. The integrated circuit (203) of claim 8, further comprising:
a first time-period generator (124) coupled to the controller (23) to receive a first set signal (Settimer) and provide a first time control signal (CDT), wherein the first time-period generator (124) is configured to extend the first time interval (Dt1) and the second time interval (Dt2) respectively in response to the first set signal (Settimer); and
a second time-period generator (224) coupled to the controller (23) to receive a second set signal (Settimer2) and provide a second time control signal (CDT2), wherein the second time-period generator (224) is configured to extend the third time interval (Dt3) and the fourth time interval (Dt4) respectively in response to the second set signal (Settimer2).

10. The integrated circuit (203) of claim 8, further comprising:
a first current level detector (129A) coupled to the controller (23) to provide a first high-side extension signal (Curdh) based on the first output current (lo) during when the first high-side power switch (125) is on and the first low-side power switch (126) is off, and provide a first low-side extension signal (Curdl) based on the first output current (lo) during when the first low-side power switch (126) is on and the first high-side power switch is off (125); and
a second current level detector (229A) coupled to the controller (23) to provide a second high-side extension signal (Curd2h) based on the second output current (lo2) during when the second high-side power switch (225) is on and the second low-side power switch (226) is off, and provide a second low-side extension signal (Curd2I) based on the second output current (lo2) during when the second low-side power switch (226) is on and the second high-side power switch (225) is off; wherein
the controller (23) is configured to extend the second time interval (Dt2) in response to the first high-side extension signal (Curdh), and extend the first time interval (Dt1) in response to the first low-side extension signal (Curdl); and wherein
the controller (23) is configured to extend the fourth time interval (Dt4) in response to the second high-side extension signal (Curd2h), and extend the third time interval (Dt3) in response to the second low-side extension signal (Curd2I).

11. The integrated circuit (203) of claim 8, wherein:
the controller (23) is configured to extend the first time interval (Dt1) between turning off the first low-side power switch (126) and turning on the first high-side power switch (125) when the first output current (lo) flowing into the third pin (105) from the load (15) is below a time extension threshold;
the controller (23) is configured to extend the second time interval (Dt2) between turning off the first high-side power switch (125) and turning on the first low-side power switch (126) when the first output current (lo) flowing from the third pin (105) to the load (15) is below the time extension threshold;
the controller (23) is configured to extend the third time interval (Dt3) between turning off the second low-side power switch (226) and turning on the second high-side power switch (225) when the second output current (lo2) flowing into the fourth pin (107) from the load (15) is below the time extension threshold; and wherein
the controller (23) is configured to extend the fourth time interval (Dt4) between turning off the second high-side power switch (225) and turning on the second low-side power switch (226) when the second output current (lo2) flowing from the fourth pin (107) to the load (15) is below the time extension threshold.

12. The integrated circuit (203) of claim 8, wherein:
the controller (23) is configured to maintain the first time interval (Dt1) at a default time period when 1) the first output current (lo) flows from the third pin (105) to the load (15) or 2) the first output current (lo) flowing into the third pin (105) from the load (15) exceeds a time extension threshold;
the controller (23) is configured to maintain the second time interval (Dt2) at the default time period when 1) the first output current (lo) flows into the third pin (105) from the load (15) or 2) the first output current (lo) flowing from the third pin (105) to the load (15) exceeds the time extension threshold;
the controller (23) is configured to maintain the third time interval (Dt3) at the default time period when 1) the second output current (lo2) flows from the fourth pin (107) to the load (15) or 2) the second output current (lo2) flowing into the fourth pin (107) from the load (15) exceeds the time extension threshold; and wherein
the controller (23) is configured to maintain the fourth time interval (Dt4) at the default time period when 1) the second output current (lo2) flows into the fourth pin (107) from the load (15) or 2) the second output current (lo2) flowing from the fourth pin (107) to the load (15) exceeds the time extension threshold.

13. An integrated circuit (103) for a class-D audio amplifier (100), comprising:
a first pin (104) configured to receive a pulse modulated signal (PWM1);
a second pin (105) configured to provide an output voltage (Vout);
a power stage (12) comprising a high-side power switch (125) and a low-side power switch (126), wherein a first end of the high-side power switch (D1) is coupled to a first power supply voltage (Vddp), a second end of the high-side power switch (S1) is coupled to a first end of the low-side power switch (D2) to form an output node, a second end of the low-side power switch (S2) is coupled to a second power supply voltage (Vssp), and the output node (122) is coupled to the second pin (105) to provide the output voltage (Vout); and
a controller (13) coupled to the first pin (104) to receive the pulse modulated signal (PWM1) and provide a first (Dr1) and a second (Dr2) switching control signals based on the pulse modulated signal (PWM1), wherein the first (Dr1) and second (Dr2) switching control signals are configured to turn on the high-side power switch (125) and the low-side power switch (126) alternately, to transition the output voltage (Vout) between the first power supply voltage (Vddp) and the second power supply voltage (Vssp); wherein
the controller (13) is configured to extend a time interval (Dt1) between turning off the low-side power switch (126) and turning on the high-side power switch (125) when an output current (lo) flowing into the second pin (105) from the load (15) is below a time extension threshold.

14. The integrated circuit (103) of claim 13, further comprising:
a current level detector (129) coupled to the controller (13) to provide a high-side extension signal (Curdh) and a low-side extension signal (Curdl), wherein the high-side extension signal (Curdh) is provided based on the output current (lo) during when the high-side power switch (125) is on and the low-side power switch (126) is off, and the low-side extension signal (Curdl) is provided based on the output current (lo) during when the low-side power switch (126) is on and the high-side power switch (125) is off; wherein
the controller (13) is configured to extend a time interval in response to the low-side extension signal (Curdl), wherein the time interval is a first time interval (Dt1); and wherein the controller (13) is configured to extend a second time interval (Dt2) between turning off the high-side power switch (125) and turning on the low-side power switch (126) in response to the high-side extension signal (Curdh).

15. The integrated circuit (103) of claim 14, wherein the current level detector (129) comprises:
a first plurality of transistors (41-50) coupled in series between the first power supply voltage (Vddp) and a first current source (55), each of the first plurality of transistors (41-50) has a control end coupled to a control end (G1) of the high-side power switch (125);
a second plurality of transistors (61-70) coupled in series between the second power supply (Vssp) voltage and a second current source (75), each of the second plurality of transistors (61-70) has a control end coupled to a control end (G2) of the low-side power switch (126);
a first comparison circuit (512) configured to provide the high-side extension signal (Curdh) via comparing a voltage across the high-side power switch (125) with a voltage across a first part of the first plurality of transistors (41-42); and
a second comparison circuit (712) configured to provide the low-side extension signal (Curdl) via comparing a voltage across the low-side power switch (126) with a voltage across a first part of the second plurality of transistors (69-70).
